# FASCICULE DE BREVET EUROPEEN

(11) **EP 1 987 530 B1**
(45) Date de publication et mention de la délivrance du brevet: **11.04.2012**
(21) Numéro de dépôt: 07730998.7
(22) Date de dépôt: 16.02.2007
(51) Int. Cl.: B82B 3/00

(54) **INSTALLATION ET PROCEDE DE NANO -FABRICATION**
ANLAGE UND VERFAHREN FÜR NANOPRODUKTION
NANOFABRICATION INSTALLATION AND PROCESS

(30) Priorité: 20.02.2006 FR 0601483
(43) Date de publication de la demande: 05.11.2008
(73) Titulaire: CENTRE NATIONAL DE LA RECHERCHE SCIENTIFIQUE (CNRS), 75794 Paris Cedex 16 (FR)
(72) Inventeur: GIERAK, Jacques, F-91220 LE PLESSIS PATE (FR)
(74) Mandataire: Cabinet Plasseraud
(86) Numéro de dépôt international: PCT/FR2007/000287
(87) Numéro de publication internationale: WO 2007/096505

(56) Documents cités:
- WO-A2-00/67290
- WO-A2-03/107375
- DE-A1-102004 032 451
- GB-A- 2 340 991
- US-A- 5 122 663
- US-A- 5 150 392
- US-A1- 2004 232 353
- US-B1- 6 313 905
- LÜTHI ROLI ET AL: "Parallel nanodevice fabrication using a combination of shadow mask and scanning probe methods" APPLIED PHYSICS LETTERS, AIP, AMERICAN INSTITUTE OF PHYSICS, MELVILLE, NY, US, vol. 75, no. 9, 30 août 1999 (1999-08-30), pages 1314-1316, XP012024706 ISSN: 0003-6951
- HAMMEL E ET AL: "Masked ion beam lithography for proximity printing" MICROELECTRONIC ENGINEERING, ELSEVIER PUBLISHERS BV., AMSTERDAM, NL, vol. 30, no. 1-4, janvier 1996 (1996-01), pages 241-244, XP004597503 ISSN: 0167-9317
- PHAN NGOC MINH ET AL: "Utilization of carbon nanotube and diamond for electron field emission devices" MICRO ELECTRO MECHANICAL SYSTEMS, 2004. 17TH IEEE INTERNATIONAL CONFERENCE ON. (MEMS) MAASTRICHT, NETHERLANDS 25-29 JAN. 2004, PISCATAWAY, NJ, USA,IEEE, US, 25 janvier 2004 (2004-01-25), pages 430-433, XP010767917 ISBN: 0-7803-8265-X
- ZAHL PERCY ET AL: "All-in-one static and dynamic nanostencil atomic force microscopy/scanning tunneling microscopy system" REVIEW OF SCIENTIFIC INSTRUMENTS, AMERICAN INSTITUTE OF PHYSICS, US, vol. 76, no. 2, 20 janvier 2005 (2005-01-20), pages 23707-23707, XP012079181 ISSN: 0034-6748
- MEISTER A ET AL: "Nanoscale dispensing of liquids through cantilevered probes" MICROELECTRONIC ENGINEERING, ELSEVIER PUBLISHERS BV., AMSTERDAM, NL, vol. 67-68, juin 2003 (2003-06), pages 644-650, XP004428930 ISSN: 0167-9317

## Description

La présente invention est relative aux installations et aux procédés de nano-fabrication.

Plus particulièrement, l'invention se rapporte principalement à une installation de nano-fabrication comprenant :
- un porte-échantillon adapté pour recevoir un échantillon présentant une surface,
- un masque de formation de l'échantillon comprenant
   - une face inférieure orientée vers le porte-échantillon,
   - une face supérieure opposée à la face inférieure et adaptée pour recevoir un faisceau de particules émis par une source en direction du porte-échantillon pour former l'échantillon,
   - et au moins une ouverture traversante entre les faces supérieure et inférieure, adaptée pour laisser passer à travers elle une partie desdites particules en direction du porte-échantillon,
- un dispositif de détection en champ proche adapté pour détecter une position relative souhaitée dudit masque et dudit échantillon,
- un dispositif de déplacement adapté pour générer un mouvement relatif dudit masque et dudit porte-échantillon pour placer le masque et l'échantillon dans ladite position relative souhaitée, indépendamment de la position relative de la source et du masque.

Le document US 6,313,905 décrit un exemple d'une telle installation. Une source par évaporation émet des amas, gouttelettes ou particules, de matière, à travers une ouverture formée dans le cantilever d'un microscope à force atomique (AFM pour « Atomic Force Microscopy ») qui est utilisé pour contrôler une position du masque par rapport à l'échantillon pendant un dépôt à travers l'ouverture.

Toutefois, un tel dispositif n'est pas entièrement satisfaisant. En effet, des études ont montré qu'une telle installation présentait des problèmes de reproductibilité dans la formation d'un dépôt à la surface de l'échantillon. En effet, l'utilisateur n'a aucun contrôle sur les particules évaporées une fois que celles-ci ont été émises par la source. Par conséquent, il est obligé de vérifier après dépôt si la surface a été formée de la manière souhaitée, par exemple en imageant la surface.

La présente invention a notamment pour but de pallier ces inconvénients.

A cet effet, selon l'invention, une installation du genre en question est caractérisée en ce que la source émet des particules chargées et en ce que le masque comprend au moins une première électrode au niveau de l'ouverture traversante adaptée pour interagir électriquement avec les particules chargées électriquement passant à travers l'ouverture.

Grâce à ces dispositions, lorsque les particules, sous forme soit élémentaire (ions), soit groupée en amas ou gouttelettes, chargées électriquement sont émises, par exemple par une source ponctuelle, par exemple du type d'ions à métal liquide, on interagit avec les particules à très grande proximité de l'échantillon. Une telle interaction électrique peut consister en un contrôle de la trajectoire et/ou de l'énergie des particules pendant leur trajet vers l'échantillon, ou en la détection électrique de leur arrivée sur l'échantillon lui-même.

En outre, l'invention est caracterisée en ce que
- ledit masque comprend en outre au moins une deuxième électrode, la première électrode étant située entre la deuxième électrode et le porte-échantillon, ladite deuxième électrode étant située au niveau de l'ouverture Dans des modes de réalisation préférés de l'invention, on peut éventuellement avoir recours en outre à l'une et/ou à l'autre des dispositions suivantes : traversante, lesdites électrodes et la surface de l'échantillon formant ensemble une lentille électrostatique adaptée pour influer électriquement sur le déplacement desdites particules chargées électriquement passant à travers l'ouverture, lors de l'application d'un potentiel électrique auxdites électrodes.

Dans des modes de réalisation préférés de l'invention, on peut éventuellement avoir recours en outre à l'une et/ou à l'autre des dispositions suivantes :
- l'installation comprend un générateur adapté pour générer un potentiel électrique dans au moins une structure choisie parmi la première électrode, la deuxième électrode et la surface de l'échantillon ;
- ladite première électrode est située sur la face inférieure dudit masque ;
- l'installation comprend un détecteur relié à ladite électrode inférieure, adapté pour détecter des particules électriques élémentaires détachées de l'échantillon par l'arrivée sur la surface des particules passant à travers l'ouverture ;
- l'installation comprend un générateur adapté pour générer un potentiel électrique entre ladite première électrode et l'échantillon, pour influer sur l'énergie cinétique des particules entre le masque et l'échantillon ;
- le dispositif de détection en champ proche comprend une tête déplaçable par rapport au porte-échantillon au voisinage de la surface de l'échantillon, ladite tête étant positionnée en une position relative connue par rapport audit masque ;
- ladite tête et ledit masque sont solidaires en déplacement dans un plan sensiblement parallèle à la surface de l'échantillon ;
- la tête comprend une pointe et un cantilever flexible, ledit masque étant formé dans une portion amincie du cantilever ;
- l'ouverture traversante comprend une fente étroite s'étendant transversalement au trajet des particules vers le porte-échantillon ;
- l'installation comprend au moins une source adaptée pour émettre ledit faisceau de particules chargées électriquement en direction du porte-échantillon pour former l'échantillon ;
- l'installation comprend un dispositif de formation de faisceau disposé entre ladite source et ledit porte-échantillons, ledit dispositif de formation étant adapté pour mettre en oeuvre au moins l'une des dispositions suivantes :
- concentration des particules émises par la source en amas,
- filtrage des amas présentant au moins une caractéristique souhaitée parmi la charge électrique, la masse, et le rapport de la charge électrique à la masse,
- déflection des amas en direction du masque ;
- l'installation comprend une pluralité de sources adaptées chacune pour émettre des particules d'un matériau différent en direction dudit porte-échantillon ;
- le masque comprend une pluralité d'ouvertures traversantes, et une première électrode au niveau de chaque ouverture traversante respective, chaque première électrode étant adaptée pour interagir électriquement avec les particules chargées électriquement passant à travers l'ouverture correspondante ;
- l'installation comprend une pluralité de sources adaptées chacune pour émettre des particules en direction dudit porte-échantillon à travers une ouverture correspondante ;
- l'installation comprend un système de positionnement de source adapté pour détecter la position relative de la source et du masque ;
- ledit système de positionnement comprend la source elle-même, configurée sous la forme d'une pointe de microscopie en champ proche, et présentant en surface extérieure le matériau formant lesdites particules, ladite pointe étant adaptée pour dans un premier mode opératoire, détecter la position relative de la pointe et du masque et, dans un deuxième mode opératoire, pour émettre lesdites particules ;
- la source comprend un réservoir dudit matériau, et un dispositif de chauffage adapté pour liquéfier le matériau contenu dans le réservoir pour faire s'écouler celui-ci le long de la pointe de la source ;
- la source est adaptée pour former ladite ouverture.

Selon un autre aspect, l'invention se rapporte principalement à un procédé de nano-fabrication dans lequel :
a) un dispositif de détection en champ proche détecte une position relative souhaitée d'un masque de formation et d'une surface d'un échantillon disposé sur un porte-échantillon,
b) un dispositif de déplacement génère un mouvement relatif dudit masque et dudit porte-échantillon pour placer le masque et l'échantillon dans ladite position relative souhaitée, indépendamment de la position relative d'une source et du masque,
   ledit masque de formation de l'échantillon comprenant
   - une face inférieure orientée vers le porte-échantillon,
   - une face supérieure opposée à la face inférieure,
   - au moins une ouverture traversante entre les faces supérieure et inférieure,
   au moins une première électrode du masque disposée au niveau de l'ouverture traversante,
   et en outre au moins une deuxième électrode, la première électrode étant située entre la deuxième électrode et le porte-échantillon, ladite deuxième électrode étant située au niveau de l'ouverture traversante,
c) on forme l'échantillon en faisant émettre à la source un faisceau de particules chargées éléctriquement en direction du porte-échantillon, une partie desdites particules passant à travers l'ouverture traversante en direction du porte-échantillon,
   au cours de l'étape c), la source émet des particules chargées électriquement, et
d), on interagit électriquement avec la particule passant à travers l'ouverture par lesdites électrodes et la surface formant ensemble une lentille électrostatique influant 30 électriquement sur la trajectoire desdites particules ;

Dans certains modes de réalisation, on peut mettre en oeuvre l'une et/ou l'autre des dispositions suivantes :
- au cours de l'étape c), une particule atteint ladite surface de l'échantillon, pour former ladite surface, et détache de ladite surface une particule élémentaire chargée électriquement,
   et au cours de l'étape d), on interagit avec les particules passant à travers l'ouverture en détectant ladite particule élémentaire chargée électriquement avec ladite première électrode ;
- au cours de l'étape d), on interagit avec la particule passant à travers l'ouverture en générant une différence de potentiel entre ladite première électrode et la surface, pour influer sur l'énergie cinétique de ladite particule au moment où elle atteint ladite surface ;
- e) on détecte la position relative de la source et de l'ouverture, et on génère un mouvement relatif de la source et de l'ouverture pour positionner la source et l'ouverture en des positions respectives adaptées pour qu'une partie du faisceau passe par l'ouverture ;
- on répète au moins les étapes a) à d) en une position relative souhaitée ultérieure ;
- on met en oeuvre en outre au moins l'une des étapes suivante :
- on concentre les particules émises par la source en amas,
- on filtre les amas présentant au moins une caractéristique souhaitée parmi la charge électrique, la masse et le rapport de la charge électrique à la masse,
- on dévie les amas en direction du masque ;
- au moins les étapes c) et d) sont mises en oeuvre successivement pour une pluralité de sources émettant des particules à travers une même ouverture du masque ;
- au moins les étapes c) et d) sont mises en oeuvre parallèlement pour une pluralité de sources émettant chacune des particules à travers chacune une ouverture respective ;
- la source forme l'ouverture traversante dans le masque.

D'autres caractéristiques et avantages de l'invention apparaîtront au cours de la description suivante de certaines de ses formes de réalisation, donnée à titre d'exemple non limitatif, en regard des dessins joints.

Une installation telle que décrite ci-dessus utilisant une seule électrode est connue du document DE-102004032451.

Sur les dessins
- la figure 1 est une vue schématique d'une installation de nano-fabrication,
- la figure 2 est une vue schématique détaillée agrandie de la partie A de la figure 1,
- la figure 3 est une vue schématique d'un exemple de réalisation d'un dispositif de formation de faisceaux pour l'installation de la figure 1,
- la figure 4 est une vue schématique correspondant à la figure 2 d'une fonction de détection mise en oeuvre avec l'installation,
- la figure 5 est une vue schématique correspondant à la figure 2 d'une fonction de formation du substrat avec l'installation,
- la figure 6 est une vue schématique en trois dimensions d'un deuxième exemple d'installation, dont a été retiré le dispositif de formation de faisceaux pour une meilleure visualisation,
- la figure 7 est une vue schématique d'un exemple de source de particules destiné à équiper l'installation de la figure 6,
- la figure 8 est un schéma correspondant sensiblement à la figure 1 pour un troisième mode de réalisation, sur laquelle les dispositifs de formation de faisceau ne sont pas représentés, et
- la figure 9 est un schéma correspondant sensiblement à la figure 8, pour un quatrième mode de réalisation.

Sur les différentes figures, les mêmes références désignent des éléments identiques ou similaires.

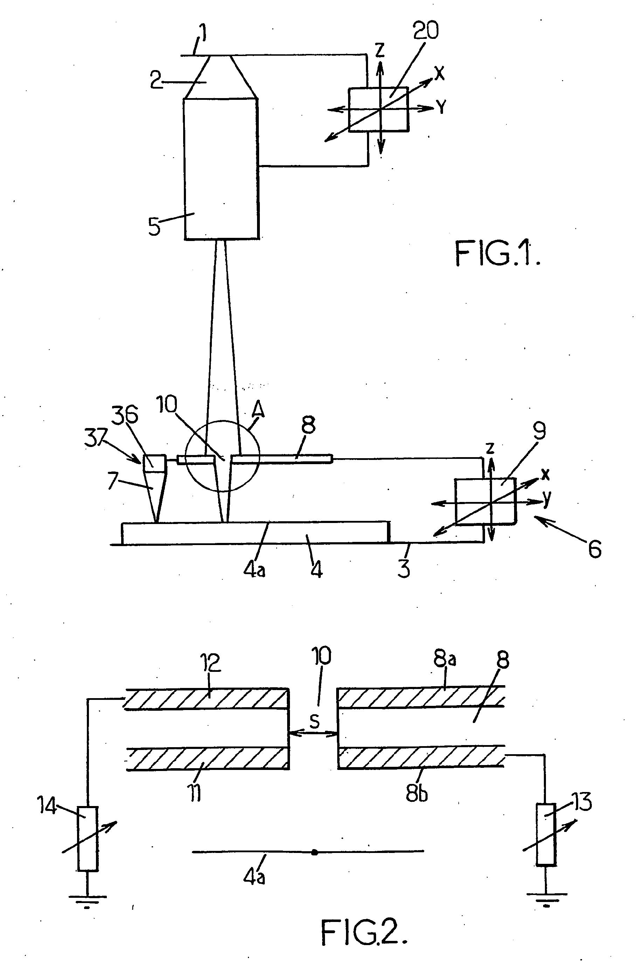

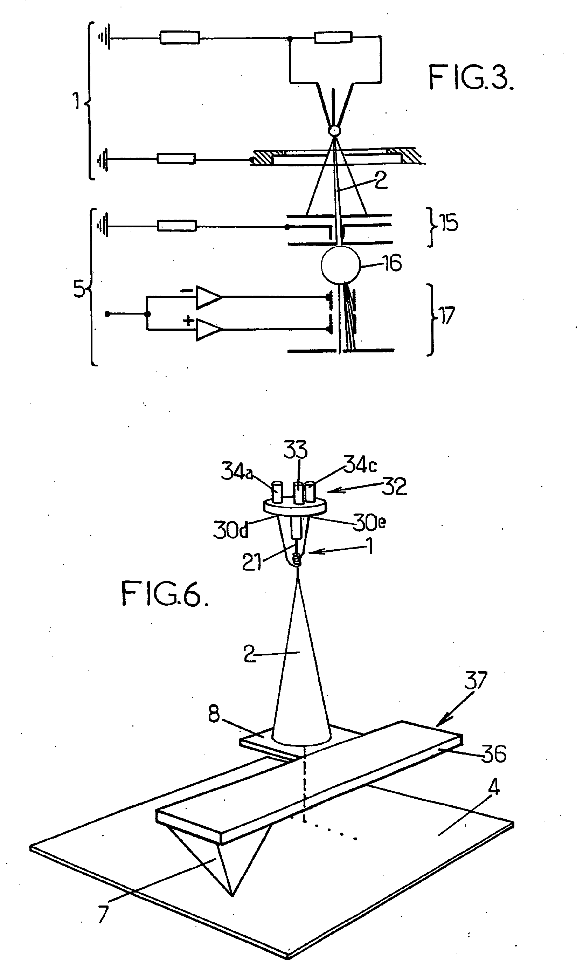

La figure 1 représente très schématiquement une installation de nano-fabrication comportant une source 1 émettant un faisceau 2 de particules de matière électriquement chargées en destination d'un échantillon 4 à former porté par un porte-échantillons 3 de l'installation. La source 1 émet un faisceau 2 de particules élémentaires (ions) et/ou d'amas, ou gouttelettes, chacun de ces amas présentant dans son ensemble une charge électrique respective. Il s'agit par exemple d'une source d'ions de métal liquide (LMIS pour « Liquid Metal Ion Source » telle que décrite par exemple dans WO 96/02065) émettant, lorsqu'elle est alimentée de manière appropriée, par exemple par un courant d'environ 40 µA d'intensité, des amas d'ions comme, par exemple, des amas d'ions or Au⁺ de taille de l'ordre du nanomètre. Ce faisceau est émis en direction de l'échantillon 4 soit directement soit par l'intermédiaire d'un dispositif de formation de faisceau 5 qui sera décrit plus en détail par la suite en relation avec la figure 3.

L'installation de la figure 1 présente également un dispositif de détection en champ proche 6 de type classique, de type microscope à force atomique (AFM pour « Atomic Force Microscopy »), ou microscopie à effet tunnel (STM pour « Scanning Tunneling Microscope ») ou autre dispositif de détection approprié. De manière classique, le microscope à force atomique comporte une tête 37 dotée d'une pointe 7 portée par une poutre ou cantilever flexible 36 (perpendiculaire au plan de la figure 1) et déplacée par un dispositif de déplacement 9 au voisinage de la surface 4a de l'échantillon à former, pour détecter le relief et/ou la composition chimique de cette surface. Par «au voisinage de la surface », on entend que la pointe 7 peut être maintenue au contact de la surface ou à très faible distance de celle-ci pour la détection de cette surface. Le dispositif de déplacement 9 peut par exemple déplacer le porte-échantillons 3 portant l'échantillon selon les directions x et y correspondants sensiblement au plan de surface 4a de l'échantillon et déplacer la tête 37 selon un axe z normal à cette surface, ou de toute autre manière appropriée. Le dispositif de déplacement est par exemple réalisé sous la forme de dispositifs piezo-électriques dont l'allongement est proportionnel à une grandeur électrique parcourant ledit dispositif afin de permettre une précision, par exemple à l'échelle nanométrique, du déplacement.

Comme également visible sur la figure 1, la tête 37 est, selon un exemple, solidaire en déplacement au moins selon les axes x et y, d'un masque 8 disposé entre la source 1 et l'échantillon 4 sur le trajet des amas, éventuellement issus du dispositif de formation de faisceau 5, en direction de l'échantillon 4. En variante, le masque 8 est maintenu dans l'installation avec une position connue à l'avance par rapport à la tête 37, à l'échelle de la résolution du dispositif de détection près. Le masque repose par exemple sur le substrat, en état surélevé par rapport à celui-ci, par des cales. Ainsi, le masque 8 peut être déplacé indépendamment de la-tête 37 pourvu que leurs positions respectives restent à tout moment connues, en étant par exemple calculées à partir de leur position respective initiale et du mouvement de l'un et/ou l'autre par rapport à cette position initiale.

Comme représenté plus en détail sur la figure 2, le masque 8 s'étend de manière sensiblement plane parallèlement au plan de la surface 4a de l'échantillon, et présente une épaisseur de l'ordre de la centaine de nanomètres. Il comporte une ouverture traversante 10 s'étendant de la surface supérieure 8a à la surface inférieure 8b du masque 8. L'ouverture traversante 10 est par exemple réalisée normalement aux surfaces supérieure et inférieure du masque 8 et présente par exemple un diamètre de l'ordre de 10 nm.

Dans l'exemple de réalisation présenté, une lentille électrostatique est réalisée à proximité de la surface 4a de l'échantillon 4 à former. Dans un exemple de réalisation purement illustratif, représenté sur la figure 2, une première électrode 11 est réalisée sur une face inférieure 8b du masque au niveau de l'ouverture 10. Une deuxième électrode 12 est réalisée, en amont de la première électrode sur le trajet source-surface des amas, par exemple sur la surface supérieure 8a du masque au niveau de l'ouverture traversante 10. L'ensemble formé de la deuxième électrode 12, de la première électrode 11, et de la surface 4a de l'échantillon forment dans l'exemple présenté, la lentille électrostatique. Un premier générateur 13 applique un premier potentiel électrique réglable à la première électrode 11, et un deuxième générateur 14 applique un deuxième potentiel électrique réglable, à la deuxième électrode 12.

Le masque 8 qui vient d'être décrit peut par exemple être réalisé par un outil de fabrication adapté du genre nano-fabrication par faisceaux d'ions focalisés (nanoFIB pour « Focused Ion Beam»). Par exemple, deux membranes de silicium sont chacune métallisée sur une face, et percée d'un trou destiné à former l'ouverture 10. Puis, ces deux membranes sont assemblées par leur face non métallisée, par exemple par collage moléculaire. Différents exemples d'empilements de deux membranes ou plus peuvent être réalisés selon les propriétés qu'on souhaite donner à la lentille.

La formation du faisceau dans un exemple utilisant le dispositif de formation de faisceaux 5 de la figure 1 est maintenant décrite en relation avec la figure 3. Le faisceau 2 émis par la source 1 est tout d'abord condensé et focalisé par une lentille électrostatique 15. Puis, on applique à ce faisceau un filtre de vitesse ExB, dit de Wien, permettant de séparer les ions, les amas globalement neutres, et les amas chargés présentant une masse, une charge, ou un rapport masse/charge électrique souhaité. Puis, un dispositif de déflection 17, par exemple réalisé sous la forme d'un double quadrupole de déflexion, est utilisé pour diriger le faisceau d'amas 2 vers un endroit précis, de l'ordre de quelques microns carrés (µm²) de superficie de la surface 4a de l'échantillon.

Dans cette description, l'ouverture 10 est un trou sensiblement ponctuel. Toutefois, on prévoit de mettre en oeuvre l'invention également pour tout type d'ouverture en forme de fente étendue sensiblement selon une direction, segment de droite, de courbe, ou autre, correspondant à un motif à déposer.

En variante, on n'utilise pas nécessairement un dispositif de faisceau tel que décrit en relation avec la figure 3. Dans ce cas, la source 1 est disposée au voisinage du masque 8, l'électrode supérieure du masque 8 pouvant servir d'extractrice pour la source 1, si l'ouverture 10 est un trou circulaire, pour garantir une symétrie du champ électrostatique nécessaire à l'extraction.

Lors de l'utilisation de l'installation, on place l'ouverture 10 en regard de l'emplacement à former de la surface 4a de l'échantillon. Ce positionnement est par exemple mis en oeuvre, à l'aide du dispositif de déplacement 9 en détectant les particularités géométriques et/ou chimiques ou autres de la surface 4a de l'échantillon, à l'aide de la pointe 7 jusqu'à identifier l'emplacement souhaité. Puis on déplace le porte-échantillons ou le masque 8 de sorte que l'ouverture traversante 10 soit au dessus de l'emplacement souhaité.

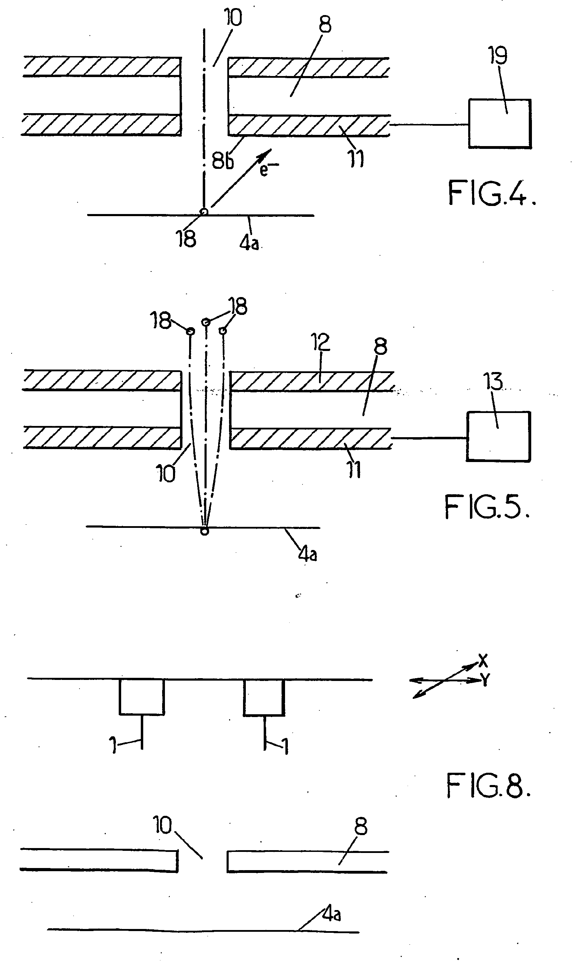

Dans un premier exemple de mise en oeuvre, comme représenté sur la figure 4, on peut, à l'aide de la première électrode 11, lorsque celle-ci est disposée sur la face inférieure 8b du masque 8, au niveau de l'ouverture 10, interagir avec les amas 18 chargés électriquement parvenant sur la surface de l'échantillon 4a. Si les amas sont chargés positivement, tels que par exemple des amas d'ions Au⁺, des électrons e⁻ vont être émis à destination de la première électrode 11, et ces électrons pourront être détectés par un détecteur approprié 19. Dans cette application, on entend par « au niveau de » que l'électrode est suffisamment proche de l'ouverture pour qu'un nombre suffisant d'électrons émis du fait de l'arrivée des amas 18 sur la surface 4a soit détecté pour fournir une information pertinente sur la quantité de matière déposée. Par cette détection, on pourra mettre en oeuvre un contrôle de la quantité d'or déposée, dans l'exemple considéré, à la surface 4a de l'échantillon, en l'emplacement souhaité, ce qui permet de contrôler la durée pendant laquelle le procédé doit être mis en oeuvre en cet emplacement. Une fois le dépôt formé, le masque peut être déplacé, par rapport à l'échantillon jusqu'à un nouvel emplacement souhaité où ces étapes sont répétées. Ce nouvel emplacement souhaité peut avoir été préalablement détecté par le dispositif de détection 6.

Selon une deuxième application, comme représenté sur la figure 5, on agit électriquement directement sur les amas 18 lors de leur trajet depuis la source 1 jusqu'à la surface 4a à former de l'échantillon. On applique par exemple un potentiel retardateur à la première électrode 11 à l'aide du premier générateur 13. L'électrode d'entrée 12 est quant à elle maintenue au potentiel de la masse ou à un autre potentiel. Par conséquent, un champ électrique est généré par la gentille électrostatique qui va avoir l'effet de focaliser les amas 18 en direction de l'emplacement souhaité 2 de la surface 4a de l'échantillon. Des vitesses de dépôt de l'ordre de 10 nm/min peuvent ainsi être obtenues. Par ailleurs, comme la masse et/ou la charge de chacun des amas 18 est sensiblement prédéterminée pour les amas arrivants au niveau du masque 8, lorsqu'on utilise un dispositif de formation de faisceaux 5, le réglage du potentiel appliqué par le premier générateur 13 à la première électrode 11 permet d'influer sur l'énergie cinétique que présentent les amas 18 au moment où ceux-ci arrivent au niveau de la surface 4a de l'échantillon 4. Il en résulte un meilleur contrôle des conditions de dépôts, ou d'implantation dans l'échantillon 4 des amas 18, ou de formation de la surface 4a. En effet, l'enrobage des amas dans la surface est directement lié à l'énergie cinétique de ceux-ci à l'arrivée. Celle-ci peut être par exemple contrôlée entre quelques centaines de Volts et 5kV.

Par « au niveau de », on entend dans cette application que l'électrode est suffisamment proche de l'ouverture pour que l'application d'un potentiel électrique à l'électrode puisse influer électriquement les amas chargés électriquement passant par l'ouverture.

Bien entendu, la détection de la formation de la surface 4a en l'emplacement considéré peut également être effectuée par la suite en déplaçant la tête 37 du dispositif de détection 6 en cet emplacement.

Puis, le masque 8 peut être déplacé vers un autre emplacement dans lequel la surface 4a de l'échantillon doit être formée. Dans cet exemple, on a présenté une lentille simple présentant un masque à deux électrodes. On peut prévoir d'augmenter le nombre d'électrodes superposées au niveau de l'ouverture pour influer de manière plus précises sur les amas. Le dispositif de détection 6 peut être déplacé indépendamment de la source 1 jusqu'à ce que l'ouverture 10 se situe au dessus du nouvel emplacement a former de la surface 4a de l'échantillon. Il suffit alors, de déplacer ou non la source 1 selon l'étendue géométrique du faisceau 2. Sans déplacer la source 1, on peut modifier des caractéristiques du dispositif de déflexion 17 du dispositif de formation de faisceaux 5 pour diriger le faisceau 2 vers le nouvel emplacement.

Pour détecter la position de l'ouverture 10 par rapport à la source 1, la source LMIS est utilisée à faible courant, en mode « Imagerie ». On peut alors ajuster la position relative de la source et du masque à l'aide du dispositif de positionnement 20, ou modifier les caractéristiques du déflecteur 17.

Le masque ne nécessite pas d'être ligné avec la source et son dispositif de formation de faisceaux, car c'est le faisceau, en mode imagerie, qui vient détecter en permanence la position du masque, et s'aligne sur l'ouverture.

L'installation peut en alternative comporter un dispositif de détection pour détecter les positions relatives de la source 1 et de l'ouverture 10.

Si il est détecté que l'ouverture 10 se rebouche lors du dépôt d'ions or sur le masque 8, à proximité de l'ouverture 10, on peut également à partir de la source 1, former non plus la surface 4a du substrat mais l'ouverture 10 elle-même en re-gravant celle-ci de manière appropriée pour qu'elle présente la forme voulue, par gravure des dépôts d'or formés à sa surface.

De plus, les aberrations de cette géométrie de lentille, avec des ouvertures de type nano-trou, sont très faibles. Le grandissement si la distance de travail est réduite à pratiquement zéro, va atteindre une valeur minimum. La limite théorique sera fixée par le phénomène de diffraction à l'échelle de l'Angström pour les particules chargées énergétiques et massives employées.

Comme représenté sur la figure 6, dans une variante de réalisation, le masque 8 n'est pas nécessairement réalisé d'une manière indépendante de la tête 37 du dispositif de détection, les positions relatives du masque 8 et de la tête 37 étant finement corrélés. Dans cette variante, le masque 8 peut être formé comme une portion du cantilever 36 de la tête 37. L'épaisseur du masque 8 étant ajustée selon les besoins entre un dixième et quelques dixièmes de microns. Le masque 8 est par exemple réalisé comme représenté par une portion amincie rapportée sur le corps du cantilever 36, afin de ne pas influer sur la rigidité et les caractéristiques en flexion du cantilever qui ont été établies avec précaution pour fournir un dispositif de détection de très grande précision et offrir une surface utile étendue pour le masque.

Cette disposition permet :
- de fabriquer puis d'utiliser une pluralité d'ouvertures ayant des formes, tailles, positions et/ou organisations variables, et pouvant être adressées par le faisceau d'amas de manière individuelle (dépôt de points, de motifs) ou collective (réseau de motifs), ce dernier cas permettant de transférer les motifs définis par le masque de manière parallèle/simultanée ;
- de protéger, par effet d'écran, de manière très efficace, les régions de la surface 4a de l'échantillon 4, voisines de l'ouverture pratiquée dans un masque, car ce masque est de superficie plus étendue que la superficie du cantilever lui-même.

Sur la figure 6 également, qui n'est pas à l'échelle, et sur laquelle le dispositif de formation de faisceaux 5 a été omis, on a également représenté une source pouvant être utilisée à la place d'une source LMIS classique. Cette source comprend une pointe 21 se présentant généralement sous la forme d'une aiguille 22 présentant un corps 23 sensiblement cylindrique s'étendant à la fois dans une portion proximale 24 et une portion médiane 25 de la pointe, et une extrémité pointue 26 s'étendant dans une portion distale 27 de la pointe en prolongement du corps 23. La géométrie externe de l'extrémité pointue 26, qui s'étend sur quelques dixièmes de millimètres est celle d'une pointe de microscope à effet tunnel. Le rayon de courbure terminal de la pointe est sensiblement compris entre 0,1 et 2 micromètres, de préférence entre 0,3 et 1 micromètre, tel que mesuré par microscopie à balayage. A ce titre, on donnera à la surface externe 26a de l'extrémité pointue 26 toute géométrie adaptée pour l'utilisation de la tête de lecture/écriture comme aiguille de microscope à effet tunnel.

L'aiguille 22 comporte un long noyau effilé 28 d'un matériau réfractaire, tel que par exemple du tungstène et, recouvert d'une fine couche 29 d'un matériau électriquement conducteur, tel que par exemple de l'or. A titre d'exemple, dans le mode de réalisation présenté, le noyau 28 est formé d'un fil de tungstène de 0,25 mm de diamètre recouvert au moins partiellement, et au moins dans la portion distale 27, d'un film d'or de quelques microns d'épaisseur.

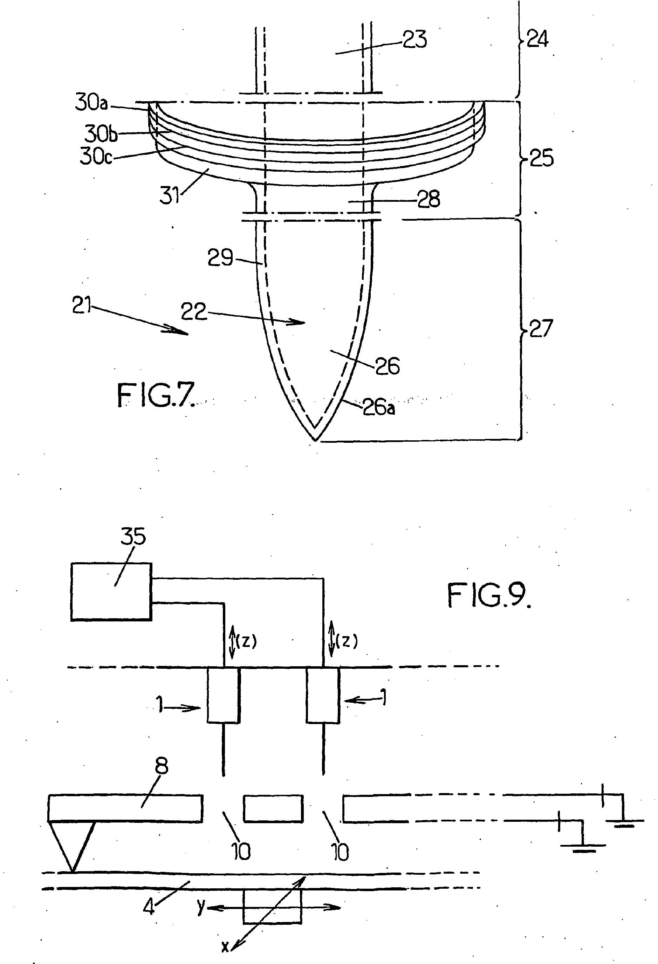

Dans la portion médiane 25 de la pointe 21 se trouvent quelques spires 30a, 30b, 30c d'un filament électrique 30. Ces spires, au nombre de trois sur la figure 7, à titre d'exemple, sont enroulées autour de l'axe longitudinal de l'aiguille 22 dans la portion médiane et sont par exemple réalisées d'un fil de tungstène d'environ 0,1 mm de diamètre. Dans l'exemple présenté, les spires forment un cercle de diamètre d'environ 0,5 mm qui entoure un réservoir 31 du matériau électriquement conducteur.

Comme représenté sur la figure 6, la pointe 21 qui vient d'être décrite, est montée sur une tête 32 telle que par exemple une tête de microscopie à effet tunnel de diamètre extérieur de quelques millimètres. Une telle tête 32 comporte par exemple un capillaire central 33 adapté à être relié à un générateur électrique (non représenté sur la figure 6) ainsi qu'une pluralité de traverses 34a, 34c isolées électriquement les unes des autres.

La pointe 21, représentée sur la figure 7, comportant l'aiguille 22 et le filament 30 comportant une première extrémité 30d et une deuxième extrémité 30e entre lesquelles s'étendent les spires 30a, 30b, 30c est connectée électriquement à la tête 32. D'une part, la portion proximale 24 de la pointe est connectée électriquement au capillaire central 33 alimenté depuis la première traverse 34a. A ce niveau, la première extrémité 10d du filament 30 est connectée électriquement à l'aiguille 22, pour former un seul point de contact électrique. Pour refermer le circuit électrique de chauffage, la deuxième extrémité 30e du filament 30 est reliée électriquement à une des traverses isolées, par exemple la traverse 34c, par exemple par sertissage, ou par soudure par points.

Les première et deuxième traverses 34a, 34c sont reliées à un générateur électrique La traverse 34c est quant à elle reliée électriquement au capillaire 33. La tête 32 est placée à proximité du masque 8. La distance entre la pointe 21 et le masque 8 est par exemple de l'ordre de la centaine de microns. Le générateur électrique est également connecté électriquement au masque 8 pour l'application d'une différence de potentiel entre le masque 8 et la pointe 21.

Un dispositif de déplacement 20 est adapté pour appliquer un mouvement relatif du masque 8 et de la pointe 1 selon une, deux ou trois dimensions. Un tel dispositif de déplacement peut être classiquement un dispositif de déplacement du type utilisé en microscopie par effet tunnel, tel que par exemple un dispositif à base d'éléments piézo-électriques capables de s'allonger sous l'effet du passage d'un courant électrique dans le matériau. Dans l'exemple présenté, comme représenté par les trois flèches, X, Y, Z, la source peut être soumise à un déplacement selon les trois directions par rapport au masque qui reste fixe. D'autres variantes de réalisation sont possibles.

Dans l'exemple présenté, le générateur électrique comporte d'une part un générateur de courant relié aux deux traverses 34a et 34c pour faire circuler un courant de chauffage dans le filament 30. Le générateur électrique comporte également un générateur de tension adapté pour appliquer une différence de potentiel d'un premier signe entre la pointe et le masque, ou une différence de potentiel d'un deuxième signe opposé au premier signe entre ces deux éléments.

Un premier générateur de tension est adapté pour utiliser la source 1 en mode d'écriture (source d'ion de métal liquide). A ce titre, on peut par exemple utiliser un générateur du type appliquant à la pointe 21 une tension positive de l'ordre de 0 à 5 kilovolts, le masque 8 étant relié à la masse. Le courant délivré par le premier générateur est de l'ordre de 1 à 10 micro ampères par exemple.

A titre de second générateur de tension, celui-ci peut appliquer une tension négative de l'ordre de quelques volts à la pointe 21 tandis que le masque 8 est reliée à la masse. Un courant pouvant être inférieur à 1 pico ampère, jusqu'à de l'ordre de 300 nanoampères peut alors circuler entre la pointe et le masque.

Le dispositif qui vient d'être décrit peut être utilisé en mode écriture en tant que source d'ion de métal liquide. En plaçant l'interrupteur sur une position appropriée, le premier générateur applique une différence de potentiel positive de l'ordre de quelques kilovolts entre la pointe 1 et le masque 8. Simultanément, le générateur de courant active le dispositif de transfert de chaleur en faisant circuler dans le filament 30 un courant suffisant (par exemple de l'ordre de quelques ampères pour la géométrie présentée) pour chauffer, au niveau des spires, le matériau électriquement conducteur à une température au moins égale à sa température de fusion. Avec la géométrie présentée, une puissance de 1,5W suffit à atteindre une température de 1000°C environ au niveau du réservoir. Dans ce mode de fonctionnement, en mode écriture par émission d'ions liquides, un cône de Taylor se forme à l'extrémité de la pointe, du fait des actions opposées du champ électrique appliqué, qui tend à arracher des ions de la pointe, et de la tension de surface du film de métal liquide recouvrant l'aiguille. La différence de potentiel appliquée entre la pointe 21 et le masque 8 forme un faisceau d'ions du métal électriquement conducteur de la couche 29 par évaporation de champ. Ceux-ci vont former la portion de l'échantillon en regard. L'érosion due à l'extraction de matière depuis la pointe 21 est compensée par l'écoulement le long de l'aiguille du matériau électriquement conducteur du réservoir 31 liquéfié par les spires du filament qui transfèrent l'énergie en provenance du générateur de courant. La matière située à l'extrémité de l'aiguille est ainsi renouvelée en permanence, ce qui permet de disposer d'un mode écriture possédant une grande longévité.

En plaçant l'interrupteur dans une deuxième position, le deuxième générateur de tension applique une différence de potentiel négative de quelques volts entre la pointe 21 et le masque 8 pour un fonctionnement en mode lecture par microscopie par effet tunnel. Sous l'effet de cette différence de potentiel, un courant de l'ordre du nanoampère par exemple circule entre la pointe 21 et le masque 8, et la pointe 21 fonctionne alors comme une pointe de microscopie à effet tunnel. Un dispositif de détection adapté, du type de ceux utilisés en microscopie par effet tunnel pour déduire une information relative, à la surface 8a du masque 8 à partir du courant mesuré est utilisé pour détecter cette information. Un tel dispositif de détection étant classique dans le domaine de la microscopie par effet tunnel, il ne sera pas décrit plus en détail ici.

Dans un mode de régénération, la géométrie extérieure de l'extrémité de l'aiguille 22 peut être renouvelée. En effet, par exemple suite à l'écriture en mode d'émission d'ion de métal liquide, l'extrémité de la pointe 21 peut avoir été soumise à une forte érosion, et il convient de renouveler la géométrie de cette extrémité pour les utilisations ultérieures de la pointe 21. Dans ce mode, sans appliquer de différence de potentiel entre la pointe 1 et le masque 8, le matériau électriquement conducteur contenu dans le réservoir est liquéfié par chauffage appliqué par le générateur de courant, pour faire s'écouler ce matériau le long de la pointe jusqu'à ce que celle-ci retrouve sa géométrie originelle.

A l'aide du dispositif qui vient d'être décrit, on peut par exemple détecter, en mode lecture, la position de l'ouverture 10. La source étant positionnée en regard de l'ouverture 10, elle émet, en mode écriture, des amas électriquement chargées, comme décrit précédemment. Comme dans les modes de réalisation précédemment décrits, le masque 8 est déplacé par rapport à l'échantillon 4 pour former d'autres emplacements de la surface supérieure de l'échantillon.

Alternativement, on peut également détecter une position choisie du masque 8 métallisé et graver dans celui-ci une ouverture 10 correspondant au motif que l'on souhaite déposer ultérieurement.

Comme représenté sur la figure 8, on peut utiliser une pluralité de sources 1 correspondant chacune à l'un ou à l'autre des modes de réalisation présentés précédemment. Ces sources peuvent comporter des matériaux différents entre elles, et être.. utilisées successivement pour déposer en un même emplacement de la surface 4a à travers l'ouverture 10 des matériaux différents. Alternativement, la pluralité de sources peut être utilisée successivement en des emplacements différents après déplacement du masque 8.

Comme représenté sur la figure 9, on peut également mettre en oeuvre un traitement parallèle de la surface 4a de l'échantillon 4 en disposant d'une pluralité de sources 1 fonctionnant chacune en regard d'une ouverture 10 formée dans le masque 8.

Deux exemples de source ont été présentés. On prévoit l'utilisation de tout autre type de source de gouttelettes électriquement chargées, par exemple de type « electron beam ion trap ».

L'installation qui vient d'être décrite peut permettre de mettre en oeuvre des dépôts en vue de restaurer des connexions électriques de micro composants électroniques.

On prévoit également d'utiliser l'installation pour mettre en oeuvre des dépôts de précurseurs pour croissance localisée, tels que des précurseurs de nano tubes de carbone, de nano-fil d'arsenure de gallium, de mémoire magnétique, ou autre.

## Revendications

1. Installation de nano-fabrication comprenant :
- un porte-échantillon (3) adapté pour recevoir un échantillon (4) présentant une surface (4a),
- un masque (8) de formation de l'échantillon comprenant
• une face inférieure (8b) orientée vers le porte-échantillon,
• une face supérieure (8a) opposée à la face inférieure et adaptée pour recevoir un faisceau de particules chargées 2) émis par une source (1) en direction du porte-échantillon pour former l'échantillon,
• au moins une ouverture traversante (10) entre les faces supérieure et inférieure, adaptée pour laisser passer à travers elle une partie desdites particules en direction du porte-échantillon,
• et au moins une première électrode (11) au niveau de l'ouverture traversante adaptée pour interagir électriquement avec les particules chargées électriquement passant à travers l'ouverture, et en outre au moins une deuxième électrode (12), la première électrode (11) étant située entre la deuxième électrode (12) et le porte-échantillon (3), ladite deuxième électrode étant située au niveau de l'ouverture traversante (10), lesdites électrodes (11 ; 12) et la
- un dispositif de détection en champ proche (6) adapté pour détecter une position relative souhaitée dudit masque (8) et dudit échantillon (3);
- un dispositif de déplacement (9) adapté pour générer un mouvement relatif dudit masque (8) et dudit porte-échantillon (3) pour placer le masque et l'échantillon dans ladite position relative souhaitée, indépendamment de la position relative de la source et du masque.
surface (4a) de l'échantillon formant ensemble une lentille électrostatique adaptée pour influer électriquement sur le déplacement desdites particules chargées électriquement passant à travers l'ouverture (10), lors de l'application d'un potentiel électrique auxdites électrodes ;

2. Installation selon la revendication 1 comprenant en outre un générateur (13 ; 14) adapté pour générer un potentiel électrique dans au moins une structure choisie parmi la première électrode, la deuxième électrode et la surface (4a) de l'échantillon.

3. Installation selon l'une des revendications précédentes dans laquelle ladite première électrode (11) est située sur la face inférieure (8b) dudit masque ;
l'installation, de préférence, comprenant en outre un détecteur (19) relié à ladite électrode inférieure, adapté pour détecter des particules électriques élémentaires détachées de l'échantillon (4) par l'arrivée sur la surface des particules passant à travers l'ouverture (10).

4. Installation selon l'une des revendications précédentes comprenant en outre un générateur (13 ; 14) adapté pour générer un potentiel électrique entre ladite première électrode et l'échantillon, pour influer sur l'énergie cinétique des particules entre le masque (8) et l'échantillon (4).

5. Installation selon l'une des revendications précédentes dans laquelle le dispositif de détection en champ proche (6) comprend une tête (37) déplaçable par rapport au porte-échantillon au voisinage de la surface de l'échantillon, ladite tête (37) étant positionnée en une position relative connue par rapport audit masque (8), et de préférence comprenant en outre l'une des caractéristiques suivantes :
- ladite tête (37) et ledit masque (8) sont solidaires en déplacement dans un plan sensiblement parallèle à la surface de l'échantillon ;
- la tête (37) comprend une pointe (7) et un cantilever flexible (36), ledit masque (8) étant formé dans une portion amincie du cantilever.

6. Installation selon l'une des revendications précédentes dans laquelle l'ouverture traversante (10) comprend une fente étroite s'étendant transversalement au trajet des particules vers le porte-échantillon.

7. Installation selon l'une des revendications précédentes comprenant en outre au moins une source (1) adaptée pour émettre ledit faisceau de particules chargées électriquement en direction du porte-échantillon (3) pour former l'échantillon ;
l'installation de préférence comprenant en outre un dispositif de formation de faisceau (5) disposé entre ladite source (1) et ledit porte-échantillon (3), ledit dispositif de formation étant adapté pour mettre en oeuvre au moins l'une des dispositions suivantes :
- concentration des particules émises par la source en amas,
- filtrage des amas présentant au moins une caractéristique souhaitée parmi la charge électrique, la masse, et le rapport de la charge électrique à la masse,
- déflection des amas en direction du masque (8) ;
la source étant de préférence adaptée pour former ladite ouverture (10).

8. Installation selon la revendication 7 comprenant l'une des caractéristiques suivantes :
- l'installation comprend une pluralité de sources (1) adaptées chacune pour émettre des particules d'un matériau différent en direction dudit porte-échantillon (3) ;
- le masque comprend une pluralité d'ouvertures traversantes (10), et une première électrode (11) au niveau de chaque ouverture traversante respective, chaque première électrode (11) étant adaptée pour interagir électriquement avec les particules chargées électriquement passant à travers l'ouverture (10) correspondante, l'installation de préférence comprenant une pluralité de sources (1) adaptées chacune pour émettre des particules en direction dudit porte-échantillon à travers une ouverture (10) correspondante.

9. Installation selon l'une quelconque des revendications 7 à 8 comprenant en outre un système de positionnement de source (20) adapté pour détecter la position relative de la source (1) et du masque (8),
dans laquelle de préférence ledit système de positionnement comprend la source (1) elle-même, configurée sous la forme d'une pointe (21) de microscopie en champ proche, et présentant en surface extérieure (26a) le matériau formant lesdites particules, ladite pointe étant adaptée pour dans un premier mode opératoire, détecter la position relative de la pointe (1) et du masque (8) et, dans un deuxième mode opératoire, pour émettre lesdites particules, et
dans laquelle de préférence la source comprend un réservoir (31) dudit matériau, et un dispositif de chauffage (30) adapté pour liquéfier le matériau contenu dans le réservoir pour faire s'écouler celui-ci le long de la pointe (21) de la source.

10. Procédé de nano-fabrication dans lequel :
a) un dispositif de détection en champ proche détecte une position relative souhaitée d'un masque de formation (8) et d'une surface (4a) d'un échantillon disposé sur un porte-échantillon (3),
b) un dispositif de déplacement (9) génère un mouvement relatif dudit masque (8) et dudit porte-échantillon (3) pour placer le masque et l'échantillon dans ladite position relative souhaitée, indépendamment de la position relative d'une source (1) et du masque (8),
ledit masque de formation (8) de l'échantillon comprenant
• une face inférieure (8b) orientée vers le porte-échantillon,
• une face supérieure (8a) opposée à la face inférieure,
• au moins une ouverture traversante (10) entre les faces supérieure et inférieure,
• au moins une première électrode (11 ; 12) du masque disposée au niveau de l'ouverture traversante (10), et en outre au moins une deuxième électrode (12), la première électrode (11) étant située entre la deuxième électrode et le porte-échantillon, ladite deuxième électrode étant située au niveau de l'ouverture traversante (10),
c) on forme l'échantillon en faisant émettre à la source (1) un faisceau de particules chargées éléctriquement en direction du porte-échantillon, une partie desdites particules passant à travers l'ouverture traversante (10) en direction du porte-échantillon,
d), on interagit électriquement avec la particule passant à travers l'ouverture par lesdites électrodes (11, 12) et la surface (4a) formant ensemble une lentille électrostatique influant électriquement sur la trajectoire desdites particules.

11. Procédé de nano-fabrication selon la revendication 10, dans lequel, au cours de l'étape c), une particule atteint ladite surface (4a) de l'échantillon, pour former ladite surface, et détache de ladite surface une particule élémentaire chargée électriquement,
et dans lequel, au cours de l'étape d), on interagit avec les particules passant à travers l'ouverture en détectant ladite particule élémentaire chargée électriquement avec ladite première électrode (11).

12. Procédé de nano-fabrication selon la revendication 10 ou la revendication 11, dans lequel, au cours de l'étape d), on interagit avec la particule passant à travers l'ouverture en générant une différence de potentiel entre ladite première électrode (11 ; 12) et la surface (4a), pour influer sur l'énergie cinétique de ladite particule au moment où elle atteint ladite surface.

13. Procédé de nano-fabrication selon l'une des revendications 10 à 12, dans lequel e) on détecte la position relative de la source (1) et de l'ouverture (10), et on génère un mouvement relatif de la source et de l'ouverture pour positionner la source et l'ouverture en des positions respectives adaptées pour qu'une partie du faisceau passe par l'ouverture.

14. Procédé de nano-fabrication selon l'une des revendications 10 à 13, dans lequel on répète au moins les étapes a) à d) en une position relative souhaitée ultérieure.

15. procédé de nano-fabrïcation selon l'une des revendications 10 à 14, dans lequel on met en oeuvre l'une des dispositions suivantes :
- au moins les étapes c) et d) sont mises en oeuvre successivement pour une pluralité de sources (1) émettant des particules à travers une même ouverture du masque ;
- au moins les étapes c) et d) sont mises en oeuvre parallèlement pour une pluralité de sources (1) émettant chacune des particules à travers chacune une ouverture respective.

## Claims

1. Nanofabrication installation comprising:
- a sample holder (3) arranged for receiving a sample (4) having a surface (4a),
- a sample forming mask (8) comprising
• a lower face (8b) oriented towards the sample holder,
• an upper face (8a) opposite to the lower face and arranged for receiving a beam (2) of charged particles emitted by a source (1) in the direction of the sample holder to form the sample,
• at least one through-opening (10) between the upper and lower faces, arranged to allow a portion of said particles to pass through it in the direction of the sample holder,
• at least one first electrode (11) at the level of the through-opening arranged in order to electrically interact with the electrically charged particles passing through the opening, and at least one second electrode (12), the first electrode (11) being positioned between the second electrode (12) and the sample holder (3), said second electrode being positioned at the level of the through-opening (10), said electrodes (11; 12) and the surface (4a) of the sample together forming an electrostatic lens adapted to exert an electrical influence on the movement of said electrically charged particles passing through the opening (10), when an electric potential is applied to said electrodes,
- a device for near-field detection (6) arranged for detecting a desired relative position of said mask (8) and said sample (3);
- a displacement device (9) arranged for generating a relative movement of said mask (8) and said sample holder (3) in order to position the mask and the sample in said desired relative position, independently of the relative position of the source and the mask.

2. Installation according to claim 1, additionally comprising a generator (13; 14) arranged for generating an electric potential in at least one structure selected from the first electrode, the second electrode and the surface (4a) of the sample.

3. Installation according to one of the preceding claims, in which said first electrode (11) is located on the lower face (8b) of said mask,
said installation, preferably additionally comprising a detector (19) connected to said lower electrode, arranged for detecting electrical elementary particles detached from the sample (4) by the arrival, on the surface, of the particles passing through the opening (10).

4. Installation according to one of the preceding claims, additionally comprising a generator (13; 14) arranged for generating an electric potential between said first electrode and the sample, in order to exert an influence on the kinetic energy of the particles between the mask (8) and the sample (4).

5. Installation according to one of the preceding claims, in which the device for near-field detection (6) comprises a head (37) that is movable relative to the sample holder in the vicinity of the sample surface, said head (37) being positioned in a known relative position in relation to said mask (8),
and preferably further comprising one of the following features :
- said head (37) and said mask (8) are integrally moveable in a plane substantially parallel to the sample surface ;
- the head (37) comprises a tip (7) and a flexible cantilever (36), said mask (8) being formed in a reduced-thickness portion of the cantilever.

6. Installation according to one of the preceding claims, in which the through-opening (10) comprises a narrow slit extending transversely to the path of the particles to the sample holder.

7. Installation according to one of the preceding claims, additionally comprising at least one source (1) arranged for emitting said beam of electrically charged particles in the direction of the sample holder (3) in order to form the sample ;
said installation preferably additionally comprising a beam shaping device (5) arranged between said source (1) and said sample holder (3), said shaping device being arranged for applying at least one of the following arrangements:
- concentration of the particles emitted by the source into clusters,
- filtering of the clusters having at least one desired characteristic selected from electric charge, mass, and the ratio of electric charge to mass,
- deflection of the clusters in the direction of the mask (8) ;
the source being preferably arranged in order to form said opening (10).

8. Installation according to claim 7, comprising one of the following features :
- the installation comprises a plurality of sources (1) each arranged to emit particles of a different material in the direction of said sample holder (3) ;
- the mask comprises a plurality of through-openings (10), and a first electrode (11) at the level of each respective through-opening, each first electrode (11) being arranged to interact electrically with the electrically charged particles passing through the corresponding opening (10),
the installation preferably comprising a plurality of sources (1) each arranged to emit particles in the direction of said sample holder through a corresponding opening (10).

9. Installation according to any one of Claims 7 to 8, additionally comprising a source positioning system (20) arranged for detecting the relative position of the source (1) and the mask (8),
in which, preferably said positioning system comprises the source (1) itself, configured in the form of a tip (21) for near-field microscopy, and having on its outer surface (26a) the material forming said particles, said tip being arranged, in a first operating mode, for detecting the relative position of the tip (1) and the mask (8) and, in a second operating mode, for emitting said particles,
and in which preferably, the source comprises a reservoir (31) of said material, and a heating device (30) for liquefying the material contained in the reservoir in order to cause the latter to flow along the tip (21) of the source.

10. Method of nanofabrication in which:
a) a device for near-field detection detects a desired relative position of a forming mask (8) and a surface (4a) of a sample arranged on a sample holder (3),
b) a positioning device (9) generates a relative movement of said mask (8) and of said sample holder (3) in order to position the mask and the sample in said desired relative position, independently of the relative position of a source (1) and the mask (8),
said sample forming mask (8) comprising
• a lower face (8b) oriented towards the sample holder,
• an upper face (8a) opposite to the lower face,
• at least one through-opening (10) between the upper and lower faces,
• at least one first electrode (11; 12) of the mask arranged at the level of the through-opening (10), and at least one second electrode (12), the first electrode (11) being positioned between the second electrode and the sample holder, said second electrode being positioned at the level of the through-opening (10),
c) the sample is formed by causing a beam of charged particles to be emitted from the source (1) in the direction of the sample holder, a portion of said particles passing through the through-opening (10) in the direction of the sample holder,
d), there is electrical interaction with the particle passing through the opening by said electrodes (11, 12) and the surface (4a) together forming an electrostatic lens exerting an electrical influence on the trajectory of said particles.

11. Method of nanofabrication according to claim 10, in which, in the course of step c), a particle reaches said surface (4a) of the sample, in order to form said surface, and detaches an electrically charged elementary particle from said surface,
and in which, in the course of step d), there is interaction with the particles passing through the opening, detecting said electrically charged elementary particle with said first electrode (11).

12. Method of nanofabrication according to claim 10 or claim 11, in which, in the course of step d), there is interaction with the particle passing through the opening, by generating a potential difference between said first electrode (11; 12) and the surface (4a), in order to exert an influence on the kinetic energy of said particle at the moment when it reaches said surface.

13. Method of nanofabrication according to one of claims 10 to 12, in which e) the relative position of the source (1) and the opening (10) is detected, and a relative movement of the source and the opening is generated, in order to position the source and the opening in appropriate respective positions so that a portion of the beam passes through the opening.

14. Method of nanofabrication according to one of claims 10 to 13, in which at least steps a) to d) are repeated in a subsequent desired relative position.

15. Method of nanofabrication according to one of claims 10 to 14, in which one of the following features is implemented :
- at least steps c) and d) are implemented successively for a plurality of sources (1) emitting particles through one and the same opening of the mask ;
- at least steps c) and d) are implemented in parallel for a plurality of sources (1) each emitting particles, each through a respective opening.

## Patentansprüche

1. Anlage für die Nanoherstellung, umfassend:
- einen Probenträger (3), der zum Aufnehmen einer eine Oberfläche (4a) präsentierenden Probe (4) ausgebildet ist,
- eine Maske (8) für die Probenbildung, umfassend
• eine zum Probenträger hin ausgerichtete Unterseite (8b),
• eine der Unterseite gegenüber liegende Oberseite (8a), welche zum Aufnehmen eines Strahls geladener Teilchen (2) ausgebildet ist, die zum Bilden der Probe von einer Quelle (1) in Richtung des Probenträgers ausgegeben werden,
• wenigstens eine Durchlassöffnung (10) zwischen der Unterseite und der Oberseite, welche dazu ausgebildet ist, einen Teil der Teilchen in Richtung des Probenträgers hindurchzulassen,
• und wenigstens eine erste Elektrode (11) auf Höhe der Durchlassöffnung, welche zum elektrischen Interagieren mit den durch die Öffnung gelangenden, elektrisch geladenen Teilchen ausgebildet ist, und wenigstens eine zweite Elektrode (12), wobei die erste Elektrode (11) zwischen der zweiten Elektrode (12) und dem Probenträger (3) angeordnet ist, wobei die zweite Elektrode auf Höhe der Durchlassöffnung (10) angeordnet ist, wobei die Elektroden (11; 12) und die Oberfläche (4a) der Probe zusammen eine elektrostatische Linse bilden, welche dazu ausgebildet ist, die Verlagerung der durch die Öffnung (10) gelangenden, elektrisch geladenen Teilchen bei Anlegen eines elektrischen Potentials an den Elektroden elektrisch zu beeinflussen;
- eine Vorrichtung zur Erkennung im Nahfeld (6), welche dazu ausgebildet ist, eine gewünschte Relativposition der Maske (8) und der Probe (3) zu erfassen;
- eine Verlagerungsvorrichtung (9), welche dazu ausgelegt ist, eine Relativbewegung der Maske (8) und des Probenträgers (3) zu erzeugen, um die Maske und die Probe unabhängig von der Relativposition der Quelle und der Maske in der gewünschten Relativposition zu platzieren.

2. Anlage nach Anspruch 1, ferner umfassend einen Generator (13; 14), welcher dazu ausgebildet ist, ein elektrisches Potential in wenigstens einer, aus erster Elektrode, zweiter Elektrode und Oberfläche (4a) der Probe gewählten Struktur zu erzeugen.

3. Anlage nach einem der vorangehenden Ansprüche, wobei die erste Elektrode (11) an der Unterseite (8b) der Maske angeordnet ist;
wobei die Anlage vorzugsweise ferner einen mit der unteren Elektrode verbundenen Detektor (19) umfasst, welcher dazu ausgebildet ist, elektrische Elementarteilchen zu erfassen, die von der Probe (4) dadurch gelöst werden, dass durch die Öffnung (10) gelangende Teilchen auf die Oberfläche treffen.

4. Anlage nach einem der vorangehenden Ansprüche, welche ferner einen Generator (13; 14) umfasst, der dazu ausgebildet ist, zum Beeinflussen der kinetischen Energie der Teilchen zwischen der Maske (8) und der Probe (4) ein elektrisches Potential zwischen der ersten Elektrode und der Probe zu erzeugen.

5. Anlage nach einem der vorangehenden Ansprüche, wobei die Vorrichtung zur Erkennung im Nahfeld (6) einen bezüglich des Probenträgers nahe der Probenoberfläche verlagerbaren Kopf (37) umfasst, wobei der Kopf (37) in einer bezüglich der Maske (8) bekannten Relativposition positioniert ist und vorzugsweise ferner eines der folgenden Merkmale aufweist:
- der Kopf (37) und die Maske (8) sind bei der Verlagerung in einer Ebene, die im Wesentlichen parallel zu der Probenoberfläche ist, solidarisch;
- der Kopf (37) umfasst eine Spitze (7) und einen flexiblen Ausleger (36), wobei die Maske (8) in einem verjüngten Abschnitt des Auslegers gebildet ist.

6. Anlage nach einem der vorangehenden Ansprüche, wobei die Durchlassöffnung (10) einen schmalen Schlitz umfasst, welcher sich quer zur Teilchenbahn hin zum Probenträger erstreckt.

7. Anlage nach einem der vorangehenden Ansprüche, welche ferner wenigstens eine Quelle (1) umfasst, die dazu ausgebildet ist, den Strahl elektrisch geladener Teilchen in Richtung des Probenträgers (3) zum Bilden der Probe auszugeben;
wobei die Anlage vorzugsweise ferner eine Strahlbildungsvorrichtung (5) umfasst, welche zwischen der Quelle (1) und dem Probenträger (3) angeordnet ist, wobei die Bildungsvorrichtung dazu ausgebildet ist, wenigstens eine der folgenden Vorgaben auszuführen:
- Konzentrieren der von der Quelle ausgegebenen Teilchen als Ansammlung,
- Filtern der Ansammlung, welche wenigstens eines der gewünschten Merkmale aus elektrische Ladung, Masse und Verhältnis von elektrischer Ladung und Masse aufweist,
- Ablenkung der Ansammlungen in Richtung der Maske (8);
wobei die Quelle vorzugsweise zum Bilden der Öffnung (10) ausgebildet ist.

8. Anlage nach Anspruch 7, umfassend eines der folgenden Merkmale:
- die Anlage umfasst eine Mehrzahl von Quellen (1), welche jeweils dazu ausgebildet sind, Teilchen unterschiedlichen Materials in Richtung des Probenträgers (3) auszugeben;
- die Maske umfasst eine Mehrzahl von Durchlassöffnungen (10) und eine erste Elektrode (11) auf Höhe jeder jeweiligen Durchlassöffnung, wobei jede erste Elektrode (11) zum elektrischen Interagieren mit den durch die jeweilige Öffnung (10) gelangenden, elektrisch geladenen Teilchen ausgebildet ist, wobei die Anlage vorzugsweise eine Mehrzahl von Quellen (1) umfasst, welche jeweils dazu ausgebildet sind, Teilchen in Richtung des Probenträgers durch eine jeweilige Öffnung (10) auszugeben.

9. Anlage nach einem der Ansprüche 7 bis 8, welche ferner ein Quellpositionierungssystem (20) umfasst, das dazu ausgebildet ist, die Relativposition der Quelle (1) und der Maske (8) zu erfassen,
wobei das Positionierungssystem vorzugsweise die Quelle (1) selbst umfasst, welche in Gestalt einer Spitze (21) für die Rastersondenmikroskopie konfiguriert ist, und an der Außenfläche (26a) das die Teilchen bildende Material umfasst, wobei die Spitze dazu ausgebildet ist, in einem ersten Betriebsmodus die Relativposition der Spitze (1) und der Maske (8) zu erfassen und in einem zweiten Betriebsmodus die Teilchen auszugeben, und wobei die Quelle vorzugsweise einen Vorratsbehälter (31) für das Material umfasst, und eine Heizvorrichtung (30), welche dazu ausgebildet ist, das in dem Vorratsbehälter befindliche Material zu verflüssigen, um dieses an der Spitze (21) der Quelle entlang fließen zu lassen.

10. Verfahren der Nanoherstellung, wobei:
a) eine Vorrichtung zur Erkennung im Nahfeld eine gewünschte Relativposition einer Probenbildungsmaske (8) und einer Oberfläche (4a) einer auf einem Probenträger (3) angeordneten Probe erfasst,
b) eine Verlagerungsvorrichtung (9) eine Relativbewegung der Maske (8) und des Probenträgers (3) erzeugt, um die Maske und die Probe in der gewünschten Relativposition zu platzieren, unabhängig von der Relativposition einer Quelle (1) und der Maske (8),
wobei die Probenbildungsmaske (8) umfasst
• eine zum Probenträger hin ausgerichtete Unterseite (8b),
• eine der Unterseite gegenüber liegende Oberseite (8a),
• wenigstens eine Durchlassöffnung (10) zwischen der Unterseite und der Oberseite,
• wenigstens eine erste, auf Höhe der Durchlassöffnung (10) angeordnete Elektrode (11; 12) der Maske und ferner wenigstens eine zweite Elektrode (12), wobei die erste Elektrode (11) zwischen der zweiten Elektrode und dem Probenträger angeordnet ist, wobei die zweite Elektrode auf Höhe der Durchlassöffnung (10) angeordnet ist,
c) die Probe gebildet wird, indem man die Quelle (1) dazu veranlasst, einen Strahl elektrisch geladener Teilchen in Richtung des Probenträgers auszugeben, wobei ein Teil der Teilchen durch die Durchlassöffnung (10) in Richtung des Probenträgers gelangt,
d) man elektrisch mit dem Teilchen interagiert, welches mittels der Elektroden (11, 12) und der Oberfläche (4a), die zusammen eine die Bahn der Teilchen elektrisch beeinflussende elektrostatische Linse bilden, durch die Öffnung gelangt.

11. Verfahren der Nanoherstellung nach Anspruch 10, wobei in Schritt c) ein Teilchen die Oberfläche (4a) der Probe zum Bilden der Oberfläche erreicht, und von dieser Oberfläche ein elektrisch geladenes Elementarteilchen löst, und wobei man in Schritt d) mit den durch die Öffnung gelangenden Teilchen interagiert, indem das elektrisch geladene Elementarteilchen mit der ersten Elektrode (11) erfasst wird.

12. Verfahren der Nanoherstellung nach Anspruch 10 oder Anspruch 11, wobei man in Schritt d) mit dem durch die Öffnung gelangenden Teilchen interagiert, indem eine Potentialdifferenz zwischen der ersten Elektrode (11; 12) und der Oberfläche (4a) erzeugt wird, um die kinetische Energie des Teilchens in dem Moment zu beeinflussen, in dem es die Oberfläche erreicht.

13. Verfahren der Nanoherstellung nach einem der Ansprüche 10 bis 12, wobei e) die Relativposition der Quelle (1) und der Öffnung (10) erfasst wird und eine Relativbewegung der Quelle und der Öffnung erzeugt wird, um die Quelle und die Öffnung in jeweiligen Positionen zu positionieren, die so ausgelegt sind, dass ein Teil des Strahls durch die Öffnung gelangt.

14. Verfahren der Nanoherstellung nach einem der Ansprüche 10 bis 13, wobei wenigstens die Schritte a) bis d) in einer nachfolgenden gewünschten Relativposition wiederholt werden.

15. Verfahren der Nanoherstellung nach einem der Ansprüche 10 bis 14, wobei eine der folgenden Vorgaben ausgeführt wird:
- wenigstens die Schritte c) und d) werden nacheinander für eine Mehrzahl von Quellen (1) ausgeführt, welche Teilchen durch dieselbe Maskenöffnung ausgeben;
- wenigstens die Schritte c) und d) werden parallel für eine Mehrzahl von Quellen (1) ausgeführt, welche jeweils Teilchen durch eine jeweilige Öffnung ausgeben.
